Europäisches Patentamt

European Patent Office

Office européen des brevets

(11) Veröffentlichungsnummer: **0 007 074**

**A1**

(12) **EUROPÄISCHE PATENTANMELDUNG**

(21) Anmeldenummer: **79102297.3**

(22) Anmeldetag: **05.07.79**

(51) Int. Cl.³: **H 03 F 3/45**
**A 61 B 5/04**

(30) Priorität: **07.07.78 DE 2830033**

(43) Veröffentlichungstag der Anmeldung:
**23.01.80 Patentblatt 80/2**

(84) Benannte Vertragsstaaten:
**CH FR IT NL**

(71) Anmelder: **HELLIGE GmbH**
**Heinrich-von-Stephan-Strasse 4**
**D-7800 Freiburg/Breisgau(DE)**

(72) Erfinder: **Weber, Horst**
**Weddigen-Strasse 6**
**D-7800 Freiburg(DE)**

(74) Vertreter: **Ter Meer-Müller-Steinmeister Patentanwälte**
**Triftstrasse 4**
**D-8000 München 22(DE)**

(54) **Verstärkeranordnung mit Störsignalunterdrückung.**

(57) Zur Gleichtaktunterdrückung bei einer vorzugsweise mit einer Mehrzahl von Operationsverstärkern ($V_1$, $V_2$, ... $V_n$) bestückten Verstärkeranordnung für eine Mehrzahl von zu verarbeitenden Nutzsignalen ($E_1$, $E_2$, ... $E_n$), die durch ein größeres Störsignal überlagert sind, ist vorgesehen, die Nutzsignale, beispielsweise physiologische Meßsignale bei EEG- und EKG-Messungen, an positiven Eingängen ( + ) der Einzelverstärker zuzuführen, während die negativen Eingängen (–) jeweils an den Verbindungspunkt eines aus zwei Widerständen bestehenden Spannungsteilers ($R_1$, $R_2$) angeschlossen sind, der jeweils zwischen dem jeweiligen Verstärkerausgang und einem Potential-Bezugspunkt (P) liegt. Dieses Bezugspotential wird durch den Ausgang eines weiteren Operationsverstärkers ($V_4$) festgelegt, an dessen positivem Eingang ein durch das Störsignal überlagertes Bezugsnutzsignal ($U_{E4}$) zugeführt wird, während sein negativer Eingang am Verbindungspunkt eines aus zwei Widerständen bestehenden Spannungsteilers ($R_2'$, $R_1'$) angeschlossen ist, der zwischen dem Ausgang dieses weiteren Operationsverstärkers und dem Potential-Bezugspunkt (P) liegt. Bei Meßsignalverstärkern, z.B für physiologische Meßsignale, erfolgt damit die Gleichtaktunterdrückung bereits in den Vorverstärkerstufen, so daß separate Differenzstufen zur Störsignalunterdrückung eingespart werden können.

# PATENTANWÄLTE
# TER MEER-MÜLLER-STEINMEISTER

**Beim Europäischen Patentamt zugelassene Vertreter — Professional Representatives before the European Patent Office
Mandataires agréés près l'Office européen des brevets**

Dipl.-Chem. Dr. N. ter Meer
Dipl.-Ing. F. E. Müller
Triftstrasse 4,
D-8000 MÜNCHEN 22

Dipl.-Ing. H. Steinmeister
Siekerwall 7,
D-4800 BIELEFELD 1

PW-413-EP
Mü/cb

5. Juli 1979

HELLIGE GMBH

Heinrich-von-Stephan-Str. 4

78oo Freiburg/Breisgau

---

Verstärkeranordnung mit Störsignalunterdrückung

---

Erfindungsgegenstand ist eine Verstärkeranordnung nach dem Oberbegriff des Patentanspruchs 1.

Die in der Verstärkertechnik häufig gestellte Aufgabe, ein kleines Nutzsignal, das von einer erheblich größeren

- 2 -

Störspannung - besonders häufig einer Netzstörung - überlagert ist, zu verstärken und weiter zu verarbeiten, wird üblicherweise mit einem Differenzverstärker mit Gleichtaktunterdrückung gelöst. Diese Lösung ist relativ problemlos, wenn zwei mit gleich großer Störspannung überlagerte Nutzsignale dem Differenzverstärker unverfälscht zugeführt werden, wenn also die Störspannung an den Eingängen des Differenzverstärkers in gleicher Größe anliegt.

Erheblichere Probleme ergeben sich jedoch, wenn die einzelnen Signale vor der Differenzbildung verstärkt und die Ausgangsimpedanz verringert werden soll. Eine solche Aufgabe stellt sich beispielsweise bei physiologischen Messungen, z.B. bei EEG-Messungen, bei denen das sehr kleine Nutzsignal durch ein um Größenordnungen stärkeres Störsignal überlagert sein kann. An die Vorverstärker für jedes Eingangssignal werden dann enorm hohe Anforderungen gestellt. Der geringste Verstärkungsunterschied zwischen den Eingangsverstärkern hat zur Folge, daß unterschiedlich große Störspannungen an den Ausgängen dieser Verstärkerstufen auftreten. Die durch diese Unterschiede entstehende Differenzstörspannung wird dann nicht mehr durch die Gleichtaktunterdrückung des nachfolgenden Differenzverstärkers unterdrückt, sondern wie ein Nutzsignal verstärkt.

Zur Überwindung dieses Problems ist es bekannt, als Bezugspunkt für die Verstärkeranordnung nicht den Schaltungsnullpunkt (beispielsweise Masse), sondern den Störpegel zu benutzen. Durch dieses Prinzip wird erreicht, daß die als Gleichtaktspannung an den Eingän-

- 3 -

gen liegende Störspannung nicht verstärkt wird, sondern in gleicher Größe  an den Ausgängen erscheint. Die
an den Ausgängen anstehende unverstärkte Störspannung
muß dann von einer nachfolgenden Differenzstufe unterdrückt werden. Ein Beispiel für eine solche Schaltungsanordnung mit mehreren Einzelverstärkern ist in der
DE-OS 24 29 953 beschrieben.

Die Gleichtaktunterdrückung in der oder den Differenzverstärkerstufe(n) hat den Nachteil, daß außer dem oder
den Vorverstärker(n) immer mindestens eine zusätzliche
Differenzbildungsstufe benötigt wird; erst an deren
Ausgang erhält man das störsignalbefreite Nutzsignal.
Für viele Meßzwecke, insbesondere bei physiologischen
Messungen, wie EEG- und EKG-Messungen, ist es jedoch
erwünscht, das einzelne Nutzsignal unmittelbar am Ausgang des Vorverstärkers zur Verfügung zu haben, um ohne
notwendigerweise zunächst über eine Differenzbildungs-
oder Differenzverstärkerstufe gehen zu müssen, direkt
eine Vielfalt von Weiterverarbeitungsmöglichkeiten
auszunutzen.

Der Erfindung liegt damit die Aufgabe zugrunde, eine
Verstärkeranordnung gemäß dem Oberbegriff des Patentanspruchs 1 zu schaffen, die sich bei wesentlich verringertem Schaltungsaufwand durch eine hohe Gleichtaktunterdrückung auszeichnet, ohne daß extreme Forderungen an die Toleranzen der Bauelemente gestellt
werden müssen. Auch wenn mehrere Signaleingänge nicht
angeschlossen sind, soll eine einwandfreie Unterdrükkung von Störsignalen gewährleistet sein.

Diese Aufgabe wird erfindungsgemäß durch die im Patentanspruch 1 angegebenen Merkmale gelöst. Vorteilhafte Weiterbildungen des Erfindungsgedankens sind in Unteransprüchen gekennzeichnet.

Eine Schaltungsanordnung mit mehreren Einzelverstärkern, die vorzugsweise aus handelsüblichen Operationsverstärkern gleichen Typs bestehen, die jeweils durch zwei zusätzliche Widerstände beschaltet sind, zeichnet sich dadurch aus, daß die Störspannung bereits in diesen Einzelverstärkern, also in den einzelnen Vorstufen, unterdrückt wird und am Ausgang nicht mehr auftritt, so daß an den einzelnen Vorstufenausgängen bei relativ niedriger Ausgangsimpedanz das oder die Nutzsignale abgegriffen und zweckentsprechend weiterverarbeitet werden können. Diese Störsignalunterdrückung in der Vorstufe wird dadurch erreicht, daß der niederimpedante Ausgang eines weiteren Einzelverstärkers, der vorzugsweise ebenfalls ein Operationsverstärker aus der Reihe der übrigen Einzelverstärker ist, einen allen übrigen Einzelverstärkern hinsichtlich eines Eingangs (vorzugsweise des Minus-Eingangs) gemeinsamen Potentialpunkt beaufschlagt. Am anderen Eingang (im gewählten Beispiel also dem Plus-Eingang) dieses weiteren Einzelverstärkers liegt ein Bezugsnutzsignal, das voraussetzungsgemäß durch das gleiche Störsignal überlagert ist wie die an den jeweils anderen Eingängen der Einzelverstärker zugeführten Nutzsignale. Am niederohmigen Ausgang des weiteren Einzelverstärkers liegt damit das um einen definierten Verstärkungsfaktor überhöhte Signal aus dem Bezugsnutzsignal und dem überlagerten Störsignal. Dieses Signal bildet das Bezugssignal für alle übrigen Einzelverstärker, die untereinander vorzugsweise mit den gleichen Widerständen, mindestens aber mit dem gleichen Widerstandsverhältnis beschaltet sind, das zum Widerstandsverhältnis an dem weiteren Einzelverstärker reziprok ist. Damit erfolgt in den Einzelstufen eine Differenzbildung zwischen dem mit Störsignal behafteten Nutzsignal dieser Stufe und dem ebenfalls mit dem gleichen Störsignal behafteten Bezugsnutzsignal, wobei das Störsignal eliminiert wird. Ein möglicher Rest an Störspannung, der unter Umständen noch an den Ausgängen der Einzelverstärker stehen kann, hängt von den Toleranzen der verwendeten Widerstände ab. In jedem Fall ist der Betrag der Störspannung jedoch ganz erheblich kleiner, was sich aus der weiter unten dargelegten rechnerischen Ableitung gut ersehen läßt.

An die Widerstände werden keine höheren Toleranzforderungen gestellt als dies bisher bei Verwendung einer nachfolgenden Differenzstufe zur Gleichtaktunterdrückung der Fall war.

Die Schaltungsanordnung zeichnet sich vor allem durch folgende Vorteile aus:

- Sieht man von der einen das Bezugssignal liefernden Stufe ab, so wird im wesentlichen nur noch die Hälfte an Bauelementen, insbesondere an Verstärkerbauelementen, benötigt. Auf die damit erreichte Kosteneinsparung ist deshalb besonders hinzuweisen, weil etwa bei physiologischen Meßgeräten wegen der oftmals extremen Spezifikation der Eingangsdaten die Vorstufen besonders teuer sind.

- Außer der Kosteneinsparung fällt für einige Anwendungszwecke auch die erhebliche Einsparung an

- 6 -

Platz ins Gewicht, was von besonderer Bedeutung ist, wenn viele Vorstufen in einer Baueinheit untergebracht werden müssen, wie dies zum Beispiel bei einem Elektrodenverteiler für EEG-Geräte mit einer Vielzahl von Elektroden der Fall ist. Hier kommt die Platzeinsparung der Forderung nach einem möglichst kleinen handlichen Elektrodenverteiler entgegen.

- Wegen der nahezu vollständigen Unterdrückung der Störspannung bereits in der Vorstufe kann das Nutzsignal im Bedarfsfall direkt weiterverarbeitet werden. Ist nachfolgend eine Differenzstufe vorgesehen, so wird diese hinsichtlich der Störsignal-, also der Gleichtaktunterdrückung, praktisch nicht mehr beansprucht. Bei gleichen eventuell noch vorhandenen Fehlerspannungen am Ausgang der Eingangsstufen, wie sie auch bisher am Ausgang der unentbehrlich vorhandenen Differenzstufen auftreten können, ergibt sich damit gegenüber den bekannten Lösungen noch der erhebliche Vorteil einer zusätzlichen Gleichtaktunterdrückung und damit einer weiteren Verbesserung hinsichtlich des Störsignalanteils.

- Nach der Verringerung der Impedanz, Gleichtaktunterdrückung und Anhebung des Signalpegels beispielsweise von EEG- unf EKG-Empfindlichkeit, kann es interessant sein, das so aufbereitete und bereinigte Nutzsignal mit elektronischen Schaltern weiterzuverarbeiten. Eine solche Schalteranordnung war auch bisher schon bei physiologischen Meßgeräten der hier erwähnten Art vorgesehen, und zwar

- 7 -

vor den Differenzstufen, die die eigentliche Gleichtaktunterdrückung erst bewirken sollen, wie beispielsweise die Schaltungsanordnung nach der genannten DE-OS 24 29 953 zeigt. Solche elektronischen Schalter haben jedoch einen Durchlaßwiderstand, der bis zu einigen loo Ohm in weiten Grenzen schwanken kann. Steht nun, wie bei bisherigen Lösungen, die Gleichtaktspannung (Störspannung) am Ausgang der Eingangsstufe, so bewirken die unterschiedlich hohen Durchlaßwiderstände eine Verfälschung der Gleichtaktspannung und damit eine Verschlechterung der Gleichtaktunterdrückung. Durch die erfindungsgemäße Schaltungsanordnung werden diese Probleme beseitigt, weil die vollständige Störsignalunterdrückung bereits in der Vorstufe erfolgt. Wird also eine vergleichbare Schaltungsanordnung wie bisher gewählt, also mit Differenzbildung nach den Vorstufen, so wird eine ganz erheblich bessere Störsignalunterdrückung erreicht, ohne daß die Durchlaßwiderstände der dazwischenliegenden Schalteranordnung besonders kritisch werden.

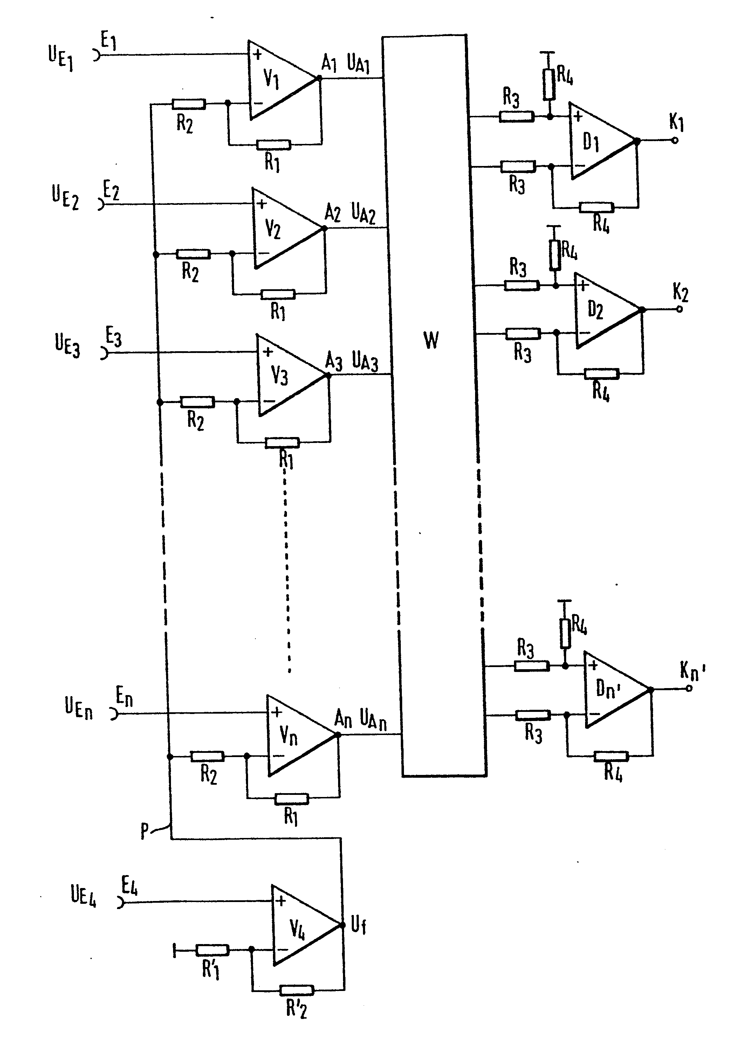

Die Erfindung und vorteilhafte Einzelheiten werden nachfolgend unter Bezug auf die Zeichnung anhand eines Ausführungsbeispiels näher erläutert.

In der einzigen Figur sind mit

$V_n$ - die Einzelverstärker von Vorstufen (z.B. n = 1 bis 25),

$E_n$, $A_n$ - die Eingänge bzw. Ausgänge der Einzelverstärker,

$U_{En}$ - die Eingangsspannung der Vorstufe $V_n$ am Eingang $E_n$,

- 8 -

$U_{An}$ - die Ausgangsspannung der Vorstufe $V_n$,

$U_f$ - die Bezugsspannung aller Vorstufen (am Punkt P)
als Ausgangsspannung des weiteren Verstärkers
(im dargestellten Beispiel des Einzelverstärkers
$V_4$),

$U_s$ - die Störspannung, die alle Eingänge $E_n$ beaufschlagt,

$R_1$, $R_2$ - die Widerstandsbeschaltung der Vorstufen,

$R_2'$, $R_1'$ - die Widerstandsbeschaltung der die Bezugsspannung $U_f$ liefernden Vorstufe (im dargestellten Beispiel $V_4$),

W - eine elektronische Verknüpfungsschaltung, als
"Ableitwähler" bezeichnet,

$D_n'$ - den Eingangsstufen über den Ableitwähler nachgeschaltete Differenzstufen (z. B. n' = 1 bis 8,
1 bis 12 oder 1 bis 16),

$K_n'$ - Ausgangsspannung der Differenzstufe $D_n'$

und mit

$R_3$, $R_4$ - die dargestellte Widerstandsbeschaltung der
Differenzstufen

bezeichnet.

Die in der Zeichnung dargestellte Schaltungsanordnung
zeigt die Anwendung der Erfindung auf ein EEG-Gerät,
bei dem die Ausgänge $A_1$ ... $A_n$ der Vorstufen $V_1$ ... $V_n$
über die als Ableitwähler W bezeichnete Wählschalteranordnung paar- und auswahlweise auf den Plus- bzw. Minus-Eingang eines jeweils ausgewählten der Differenzverstärker $D_1$ ... $D_n'$ schaltbar sind. Der Aufbau und
die Wirkungsweise der Differenzverstärker sind an sich bekannt und bedürfen hier keiner weiteren Erläuterung. Das Verhältnis der Widerstände $R_4/R_3$ kann größer als 1 gewählt werden, wenn eine zusätzliche Anhebung des Nutzsignals erwünscht ist. Bei einem erprobten Ausführungsbeispiel wurde das Verhältnsi $R_4/R_3 = 1$ gewählt mit $R_3 = R_4 = $ lo k$\Omega \pm$ 1 %. Sowohl für die Eingangsstufen $V_1 \ldots V_n$ als auch für die Differenzstufen $D_1 \ldots D_n'$ wurden bei dem erprobten Ausführungsbeispiel Operationsverstärker-Bausteine des Typs OP o5 C verwendet.

Bei einem EEG-Gerät sind beispielsweise 25 Meßelektroden vorhanden, die dementsprechend 25 Elektrodensignale abgeben, die durch 25 Eingangsstufen im Elektrodenverteiler des EEGs auf einen ausreichenden Nutzsignalpegel bei erfindungsgemäßer Unterdrückung des Störsignalpegels angehoben werden.

Die Bezugsspannung $U_f$ am für alle Eingangsstufen gemeinsamen Bezugspunkt P wird über den Eingang $E_4$ (vierte Elektrode) gewonnen; diese Bezugsspannung setzt sich aus dem Bezugsnutzsignal $U_{E4}$ und dem alle Eingänge beaufschlagenden Störsignal zusammen. Anstelle der in dem dargestellten Beispiel verwendeten vierten Elektrode kann auch jede beliebige andere Elektrode verwendet werden. Ebenso kann der hier herausgezeichnete Vorverstärker $V_4$ durch einen separaten anderen Verstärker, insbesondere Operationsverstärker mit zwei Eingängen, ersetzt sein. Eine zusätzliche Elektrode zu den im Programm beispielsweise eines kommerziellen EEG- oder EKG-Geräts benötigten ist nicht erforderlich.

Bei der gezeigten Schaltung sind die vom jeweiligen Ausgang $A_1$, $A_2$, $A_3$, $A_5 \ldots A_n$ zum zugeordneten Minus-Eingang liegende Widerstände $R_1$ alle gleich. Entspre-

- 1o -

chend sind auch die vom jeweiligen Minus-Eingang zum gemeinsamen Schaltungspunkt P führenden Widerstände $R_2$ alle mit gleichem Widerstandswert gewählt. Diese gleiche Wahl der Widerstandsbeschaltung der Vorverstärker wird sich zwar für die Praxis der meisten Anwendungsfälle empfehlen, schon um die Widerstandstoleranzen in vergleichbaren kleinen Grenzen zu halten. Eine Voraussetzung für das Funktionieren der Schaltung ist dies jedoch nicht. Entscheidend ist lediglich, daß das Verhältnis der Widerstände $R_1/R_2$ bei allen Vorstufen, die nicht zur Erzeugung der Bezugsspannung dienen, gleich ist. Für die zur Erzeugung der Bezugsspannung verwendete Vorstufe (im dargestellten Beispiel die Vorstufe $V_4$) ist die Widerstandsbeschaltung mit $R_2'$ bzw. $R_1'$ bezeichnet. Für die Praxis bietet sich in den meisten Fällen an, $R_2' = R_2$ und $R_1' = R_1$ zu wählen. Wichtig ist allerdings auch hier nur, daß das Verhältnis $R_2'/R_1'$ dem Verhältnis $R_2/R_1$ bzw. dem Reziproken des Verhältnisses $R_1/R_2$ entspricht. Bei einem erprobten Ausführungsbeispiel der Schaltung wurde $R_1 = R_1' = 5oo\ k\Omega \pm$ 1 %o und $R_2 = R_2' = 1o\ k\Omega \pm 1$ %o gewählt.

Es soll zunächst das Verhalten der Schaltung hinsichtlich der Nutzsignale betrachtet werden.

Die Ausgangsspannungen $U_{A1} \ldots U_{An}$ ergeben sich mit Bezug auf die Schaltungsdarstellung zu:

$$U_{An} = U_{En} \cdot (1 + \frac{R_1}{R_2}) - U_f \cdot \frac{R_1}{R_2} \qquad (1)$$

$$U_f = U_{E4} \cdot (1 + \frac{R_2'}{R_1'}) \qquad (2)$$

Gleichung (2) in Gleichung (1) eingesetzt ergibt:

$$U_{An} = U_{En} \left(1 + \frac{R_1}{R_2}\right) - U_{E4} \left(1 + \frac{R_2{'}}{R_1{'}}\right) \cdot \frac{R_1}{R_2}, \text{ wegen}$$

$$\frac{R_2{'}}{R_1{'}} = \frac{R_2}{R_1} \quad \text{folgt:}$$

$$U_{An} = U_{En} \left(1 + \frac{R_1}{R_2}\right) - U_{E4} \left(1 + \frac{R_1}{R_2}\right)$$

$$U_{An} = (U_{En} - U_{E4}) \left(1 + \frac{R_1}{R_2}\right)$$

$$U_{An} = (U_{En} - U_{E4}) \cdot V \text{ mit } V = 1 + \frac{R_1}{R_2} \qquad (3)$$

Die Bezugsspannung $U_f$ am gemeinsamen Schaltungspunkt P fällt also heraus, und die Ausgangsspannungen $U_{A1}$, $U_{A2}$, ... $U_{An}$ ergeben sich als um den wählbaren Verstärkungsfaktor V verstärkten Differenzwert zwischen der jeweiligen Eingangsspannung und der Bezugsspannung, so daß das Störsignal bei der Differenzbildung in der jeweiligen Vorstufe durch Gleichtaktunterdrückung beseitigt wird. Die verstärkten relativ niederohmigen Ausgangssignale der Vorstufen lassen sich bereits an dieser Stelle prinzipiell beliebig weiterverarbeiten. Beim dargestellten Schaltungsaufbau werden diese Ausgangsspannungen jeweils paarweise über den erläuterten Ableitwähler einem der Differenzverstärker zugeführt. An den Ausgängen $K_1$ bis $K_n{'}$ ergeben sich dann zum Beispiel die folgenden Spannungen:

- 12 -

$$K_1 = U_{A1} - U_{A2} = (U_{E1} - U_{E4}) \cdot V - (U_{E2} - U_{E4}) \cdot V =$$

$$(U_{E1} - U_{E2}) \cdot V \qquad\qquad (4)$$

$$K_2 = U_{A2} - U_{An} = (U_{E2} - U_{E4}) \cdot V - (U_{En} - U_{E4}) \cdot V =$$

$$(U_{E2} - U_{En}) \cdot V \quad \text{usw.} \qquad\qquad (5)$$

Wird diese Ableitung durch Differenzbildung gewählt, so tritt keine Verfälschung der Signalspannung auf, da die erste Differenzbildung mit $U_{E4}$ in der Vorstufe durch die zweite Differenzbildung aufgehoben wird.

Auch die Differenzbildung (Ableitung) zwischen $U_{E4}$ und irgendeinem der übrigen Eingänge ist sehr einfach möglich:

An den Ausgängen der Eingangsstufen liegt die mit dem Verstärkungsfaktor V multiplizierte Differenzspannung zwischen jedem Eingang und $U_{E4}$ am Bezugseingang vor. Die gewünschte Ableitung zwischen $U_{En}$ und $U_{E4}$ wird auf den einen Eingang des gewählten Differenzverstärkers $D_n'$ gegeben und der andere Eingang wird auf null Volt gelegt. Wird der Ausgang der betreffenden Eingangsstufe beispielsweise auf den nicht invertierenden Eingang des gewählten Differenzverstärkers gegeben, so ergibt sich die Ableitung $(U_{En} - U_{E4})$. Wird der Ausgang der Eingangsstufe dagegen auf den invertierenden Eingang des Differenzverstärkers geschaltet, so ergibt sich die Ableitung $(U_{E4} - U_{En})$.

Nachfolgend wird die Wirkungsweise der Schaltung aus-

- 13 -

schließlich hinsichtlich der Störspannungen betrachtet. Zur Unterscheidung von den vorhergehenden Nutzsignalbetrachtungen sind die abgeleiteten Spannungen jeweils mit einem zusätzlichen Index "S" gekennzeichnet. Der Betrachtung liegen folgende Annahmen zugrunde:

1. Die Störspannung $U_S$ liegt an allen Verstärkereingängen $E_n$ mit gleicher Amplitude und Phasenlage an.

2. Die Widerstände $R_1$ bzw. $R_2$ haben untereinander den gleichen Toleranzbereich.

3. Für die Widerstände $R_1'$, $R_2'$ gilt: $R_1' = R_1$ und $R_2' = R_2$.

Mit der Widerstandstoleranz $F = \frac{T}{100}$ (T = Widerstandstoleranz in %) und unter Berücksichtigung der möglichen Toleranzabweichungen lassen sich für die Widerstände folgende Beziehungen ansetzen:

$$R_{1F} = R_1 (1 + F_1); \quad R_{2F} = R_2 (1 + F_2) \qquad (6)$$

Der Toleranzfaktor F kann positiv oder negativ sein.

Voraussetzungsgemäß und in der Praxis sind die Störspannungen an den Eingängen gleich, das heißt, es gilt:

$$U_{E1S} = U_{E2S} = U_{E(n-1)S} = U_{ES}$$

Werden zunächst die Toleranzen vernachlässigt, so ergibt sich mit der an den Eingängen $E_1$ bis $E_n$ auftretenden Störspannung $U_S$ analog zur obigen Gleichung (1):

0007074

TER MEER · MÜLLER · STEINMEISTER          Hellige GmbH PW-413-EP

- 14 -

$$U_{AS} = U_S \left(1 + \frac{R_1}{R_2}\right) - U_{fS} \cdot \frac{R_1}{R_2}$$

Mit $U_{fS} = U_S \left(1 + \frac{R_2}{R_1}\right)$ folgt:

$$U_{AS} = U_S \left[1 + \frac{R_1}{R_2} - \frac{R_1}{R_2} - 1\right] = 0 \qquad (7)$$

Unter Berücksichtigung der Toleranzen ergibt sich für die Ausgangsspannung folgendes:

$$U_{AS} = U_S \left(1 + \frac{R_1}{R_2} \cdot a\right) - U_S \left(1 + \frac{R_2}{R_1} \cdot b\right) \frac{R_1}{R_2} \cdot a \qquad (8)$$

Mit $a = \frac{1 + F_2}{1 + F_1}$ und $b = \frac{1 + F_1}{1 + F_2}$ folgt daraus:

$$U_{AS} = U_S (1 - a \cdot b) \qquad (9)$$

Der sich auf den Bezugssignalverstärker beziehende Faktor b ist für alle Verstärker konstant, so daß nicht sämtliche möglichen Fehlerkombinationen im Einzelfall betrachtet werden müssen. Der kleinste Wert für a . b ergibt den größten Wert der Rest-Störspannung $U_{AS}$ am Ausgang.

Zur Ermittlung der maximalen Rest-Störspannung werden in den Faktoren a und b die Beträge der Widerstandstoleranz angesetzt. Unter Berücksichtigung von Gleichung (8) ergibt sich damit:

$$U_{AS} = U_S \left[1 - \frac{(1 - |F_2|)(1 - |F_1|)}{(1 + |F_1|)(1 + |F_2|)}\right] \qquad (10)$$

- 15 -

Die größte Differenz zwischen zwei Ausgangsspannungen ergibt sich, wenn der Faktor a·b bei einem bestimmten Verstärker der Beziehung

$$a \cdot b = \frac{(1 + |F_2|) \cdot (1 + |F_1|)}{(1 - |F_1|) \cdot (1 - |F_2|)}$$

genügt und für den zweiten Verstärker a·b = 1 gilt.

Die Gleichtaktunterdrückung CMRR einer beliebigen Eingangsstufe errechnet sich zu:

$$CMRR = \left( \frac{U_S}{U_{xS} - U_{yS}} \right) \cdot V \qquad (11)$$

Mit $U_{xS}$ und $U_{yS}$ sind zwei beliebige Stör-Ausgangsspannungen $U_{A1S}$ bis $U_{A(n-1)S}$ bezeichnet. Mit $F_1$, $F_2 \longrightarrow 0$ ergibt sich aus Gleichung (11): CMRR $\longrightarrow \infty$.

Das beschriebene Anwendungsbeispiel der Erfindung bezog sich auf den Eingangsteil eines EEG-Geräts mit 25 physiologischen Meßelektroden. Die Anwendung der Erfindung ist jedoch nicht auf EEG- und EKG-Geräte beschränkt. Vielmehr läßt sie sich mit Vorteil überall dort (vorzugsweise bei mehreren gleichzeitig zu erfassenden Meßpunkten) an einem Meßobjekt einsetzen, wo es darauf ankommt, ein kleines Nutzsignal auf einen zur weiteren Verarbeitung ausreichenden Pegel anzuheben, wenn gleichzeitig ein starkes Störsignal vorhanden ist. Meßprobleme dieser Art treten nicht nur in der physiologischen Meßtechnik, sondern auch in anderen Gebieten

0007074

– 16 –

der Technik auf, beispielsweise in der seismischen Datentechnik, in der chemo-technischen Meßtechnik, auf dem Gebiet der zerstörungsfreien Werkstoffprüfung, in der Unterwasser-Sonartechnik usw. Im Rahmen des Erfindungsgedankens ist auch eine Reihe von Abwandlungen der erfindungsgemäßen Verstärkeranordnung möglich, insbesondere bei der Gestaltung des für die Gewinnung des Bezugssignals verwendeten Einzelverstärkers.

- 17 -

Patentansprüche

1.    Verstärkeranordnung für eine Mehrzahl von einzeln erfaßten und zu verarbeitenden Nutzsignalen, die durch ein vergleichsweise großes Störsignal überlagert sind, mit einer Mehrzahl von gleichen Einzelverstärkern mit je einem Plus-Eingang, an dem ein bestimmtes durch das Störsignal überlagertes Nutzsignal zuführbar ist, und mit je einem Minus-Eingang, der jeweils über einen zugeordneten ersten Widerstand mit dem betreffenden Verstärkerausgang und über einen zugeordneten zweiten Widerstand mit einem allen Einzelverstärkern gemeinsamen Potentialpunkt verbunden ist, wobei die Verhältniswerte aus jeweils erstem und zweitem Widerstand für die einzelnen Verstärker gleich sind, d a d u r c h   g e k e n n z e i c h n e t , daß zur Störsignalunterdrückung der gemeinsame Potentialpunkt (P) an den Ausgang eines weiteren Verstärkers ($V_4$) mit einem Plus- und einem Minus-Eingang angeschlossen ist, dessen Ausgang über einen dritten Widerstand ($R_2'$) mit seinem Minus-Eingang verbunden ist, der seinerseits über einen vierten Widerstand ($R_1'$) auf Bezugspotential (z. B. Masse) liegt, während am Plus-Eingang dieses weiteren Verstärkers ein durch das Störsignal überlagertes Bezugsnutzsignal anliegt, und daß der aus dem dritten und vierten Widerstand gebildete Verhältniswert dem reziproken Verhältniswert aus einem ersten ($R_1$) und einem zugeordneten zweiten Widerstand ($R_2$) entspricht.

2.    Verstärkeranordnung nach Anspruch 1, d a -
d u r c h   g e k e n n z e i c h n e t , daß die ersten Widerstände ($R_1$) mit jeweils gleichem und die
zweiten Widerstände ($R_2$) mit jeweils gleichem Widerstandswert gewählt sind.

3.    Verstärkeranordnung nach Anspruch 2, d a -
d u r c h   g e k e n n z e i c h n e t , daß der Wert
des dritten Widerstands ($R_2'$) gleich einem der zweiten
und der Wert des vierten Widerstands ($R_1'$) gleich einem
der ersten Widerstände gewählt ist.

4.    Verstärkeranordnung nach einem der vorstehenden
Ansprüche, d a d u r c h   g e k e n n z e i c h -
n e t , daß jeder der Einzelverstärker ein Operationsverstärker mit gleichen Kennwerten ist.

5.    Verstärkeranordnung nach einem der vorstehenden
Ansprüche, d a d u r c h   g e k e n n z e i c h -
n e t , daß der weitere Verstärker ein Verstärker mit
hohem Verstärkungsgrad, vorzugsweise ein Operationsverstärker, ist.

6.    Verstärkeranordnung nach einem der vorstehenden
Ansprüche, d a d u r c h   g e k e n n z e i c h -
n e t , daß die Ausgänge ($A_1$, $A_2$ ... $A_n$) der Einzelverstärker ($V_1$, $V_2$ ... $V_n$) über eine Wählschaltung (W)
auswahl- und paarweise auf den Minus- bzw. Plus-Eingang eines aus einer Mehrzahl von Differenzverstärkern
($D_1$, $D_2$, ... $D_n'$) schaltbar sind.

0007074

HELLIGE GM

# EUROPÄISCHER RECHERCHENBERICHT

Europäisches Patentamt

Nummer der Anmeldung

EP 79 102 297.3

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| D | FR - A - 2 275 183 (SIEMENS) <br> * Seite 3, Zeile 7 bis Seite 5, Zeile 31; Fig. * <br> & DE - A - 2 429 953 <br> -- <br> FR - A - 2 275 185 (SIEMENS) <br> * Seite 2, Zeile 26 bis Seite 7, Zeile 7; Fig. 1, 2, 3 * <br> ---- | 1,2, 4,6 <br><br><br><br> 1,2, 4,6 |

### KLASSIFIKATION DER ANMELDUNG (Int.Cl.3)

H 03 F 3/45
A 61 B 5/04

### RECHERCHIERTE SACHGEBIETE (Int. Cl.3)

A 61 B 5/04
H 03 F 3/45
H 03 F 3/68

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 18-09-1979 | BORRELLY |